# FASCICULE DE BREVET EUROPEEN

(11) **EP 1 299 951 B1**
(45) Date de publication et mention de la délivrance du brevet: **22.03.2006**
(21) Numéro de dépôt: 01949564.7
(22) Date de dépôt: 28.06.2001
(51) Int. Cl.: H03L 7/18

(54) **PROCEDE ET DISPOSITIF DE SYNTHESE DE FREQUENCE AU MOYEN D'UNE BOUCLE A PHASE ASSERVIE**
VERFAHREN UND ANORDNUNG ZUR FREQUENZSYNTHESE MIT EINER PHASENREGELSCHLEIFE
METHOD AND DEVICE FOR FREQUENCY SYNTHESIS USING A PHASE LOCKED LOOP

(30) Priorité: 30.06.2000 FR 0008491
(43) Date de publication de la demande: 09.04.2003
(73) Titulaire: TCL & ALCATEL MOBILE PHONES LIMITED, China Hong Kong City, 33 Canton Road, Tsim Sha Tsui,Kowloon, Hong Kong (CN)
(72) Inventeur: BRUNET, Arnaud, F-78240 Chambourcy (FR); RIEUBON, Sébastien, F-38430 Moirans (FR)
(74) Mandataire: Feray, Valérie
(86) Numéro de dépôt international: PCT/FR2001/002064
(87) Numéro de publication internationale: WO 2002/001721

(56) Documents cités:
- EP-A- 0 482 823
- EP-A- 0 641 082
- EP-A- 0 727 877
- WO-A-01/24374
- US-A- 5 420 545

## Description

La présente invention concerne le domaine de la synthèse de fréquences, en particulier à des fins de modulation et de démodulation de signaux, et a pour objet un procédé et un dispositif de synthèse de fréquence utilisant une boucle à phase asservie et présentant un temps de verrouillage de phase réduit.

On connaît déjà de nombreux procédés et dispositifs réalisant; notamment par l'intermédiaire d'une boucle asservie en phase, la synthèse de fréquences en fournissant un signal de sortie dont la fréquence est un multiple entier de la fréquence d'un signal de référence. Dans ces procédés et dispositifs, le signal de sortie est, normalement après division en fréquence, comparé à un signal de référence et la différence de phase utilisée pour piloter la sortie.

Généralement, le signal de sortie est généré par un oscillateur contrôlé en tension (VCO) auquel est appliqué, après filtrage, le signal de sortie du comparateur de phase en tant que signal d'entrée de commande en fréquence.

Ces procédés et dispositifs trouvent notamment application dans les modules d'émission et de réception des systèmes de communication, en particulier de radiocommunication, en tant que moyens pour changer de canaux d'émission ou de réception.

Plus récemment ont été développés des synthétiseurs de fréquence intégrant des diviseurs fractionnaires de fréquences dans leur boucle à phase asservie et permettant virtuellement de fournir n'importe quelle fréquence en signal de sortie.

Lors des changements de canal, il y a lieu de modifier la fréquence du signal de sortie et donc de verrouiller la boucle à asservissement de phase sur ladite nouvelle fréquence.

Ces procédures de changements de fréquence et de verrouillage entraînent des délais d'attente non négligeables, une consommation inutile d'énergie et un inconfort d'utilisation gênant.

Pour réduire la durée de ces procédures, il a notamment été proposé de mettre en oeuvre une boucle à phase asservie à division fractionnaire, avec une variation de la bande de fréquence de coupure et utilisant la précharge d'une capacité antérieure.

Toutefois, cette solution est difficile et délicate à réaliser, nécessite des sorties supplémentaires et une surface d'implémentation additionnelle et entraîne d'avantage de consommation énergétique.

Le document EP 0 641 082 A2 montre un synthétiseur à boucle à verrouillage de phase fonctionnant selon deux modes différents: un premier mode à division fractionnaire activé lors de la synchronisation de la boucle, un deuxième mode à division entière activé lors fonctionnement stable de la boucle. Ceci est réalisé grâce a deux comparateurs de phase comparants chacun des signaux prélevés à différents endroits des chaînes de division de fréquence pour les signaux de référence et de feed-back. Un sélecteur contrôlé par un circuit de détection de verrouillage assure la sélection de l'un ou l'autre comparateur de phase.

Le document WO 01/24374 A1 montre une boucle à verrouillage de phase qui fonctionne en mode à division fractionnaire durant la période de synchronisation et en mode à division entière durant la période de fonctionnement stable. L'activation de l'un ou l'autre mode est réalisée en masquant ou non une partie des impulsions des signaux entrant dans un unique comparateur de phase.
De ce fait la demande comporte des revendications particulières pour les pays DE, FR, GB pour lesquels le contenu de ce document est considéré comme compris dans l'état de la technique pour juger de la nouveauté de l'invention.

La présente invention a notamment pour but de pallier les inconvénients précités et de proposer une solution autorisant une amélioration importante du temps de verrouillage mettant en oeuvre une boucle asservie en phase fractionnaire, sans génération de parasites nuisibles en environnement radio.

A cet effet, la présente invention a pour un objet un procédé de synthèse de fréquence au moyen d'une boucle à phase asservie, comportant un comparateur de phase, comprenant notamment une étape de commutation d'un mode de fonctionnement à division fréquentielle fractionnaire en un mode de fonctionnement à division fréquentielle entière après écoulement du temps ou délai de stabilisation en fonctionnement de ladite boucle, procédé caractérisé en ce qu'il consiste à opérer ladite commutation de modes de fonctionnement en masquant ou en supprimant une partie des impulsions des signaux de référence et de comparaison avant leur application aux entrées du comparateur de phase.

Elle a également pour objet un dispositif synthétiseur de fréquence à boucle à phase asservie, comprenant un générateur dont la fréquence contrôlée du signal de sortie est fonction du signal délivré par un comparateur de phase dont les entrées reçoivent un signal de référence et un signal de comparaison issu d'une chaîne de rétroaction reliant la sortie dudit générateur à fréquence contrôlée à l'une des entrées dudit comparateur de phase et intégrant un diviseur de fréquence fractionnaire, caractérisé en ce qu'il comprend également un générateur de signaux de masquage ou de suppression appliqués, en tant que signaux de commande ou d'autorisation, à des circuits discriminateurs ou filtrants montés en sérié, l'un, dans la ligne de transmission du signal de référence et, l'autre, dans la chaîne de rétroaction immédiatement en amont des entrées correspondantes du comparateur de phase, la commutation d'un mode de fonctionnement en boucle à phase asservie à division fréquentielle fractionnaire en un mode de fonctionnement en boucle à phase asservie à division fréquentielle entière étant réalisée par application desdits signaux de masquage ou de suppression.

L'idée de base de la présente invention réside dans la commutation d'une boucle asservie en phase à division fractionnaire (sans implémentation additionnelle) en une boucle asservie en phase traditionnelle (à division entière) après le délai de stabilisation, avec ou sans modification de la bande passante de ladite boucle à phase asservie, et, en tout état de cause, sans génération de parasites.

La solution proposée par l'invention entraîne le masquage de certaines impulsions, de telle manière que le comparateur de phase soit activé comme dans une boucle à phase asservie traditionnelle, ce après un certain délai.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
la figure 1 est un schéma blocs synoptique d'un dispositif synthétiseur de fréquence selon l'invention,
la figure 2 représente les chronogrammes des signaux de référence, de comparaison et de masquage avant commutation (mode de fonctionnement en boucle asservie fractionnaire), et,
la figure 3 représente les chronogrammes des signaux de référence, de comparaison et de masquage après commutation (mode de fonctionnement en boucle asservie classique).

La présente invention concerne un procédé de synthèse de fréquence au moyen d'une boucle à phase asservie 2, comportant un comparateur de phase 3, comprenant notamment une étape de commutation d'un mode de fonctionnement à division fréquentielle fractionnaire en un mode de fonctionnement à division fréquentielle entière après écoulement du temps ou délai de stabilisation en fonctionnement de ladite boucle 2.

Conformément à l'invention, ladite commutation de mode de fonctionnement est réalisée en masquant ou en supprimant périodiquement une partie des impulsions des signaux de référence Sref et de comparaison Scomp avant leur application aux entrées du comparateur de phase 3.

Préférentiellement, ledit masquage ou ladite suppression débute après un délai prédéterminé (pouvant être déterminé préalablement, en terme de valeur optimale, par expérimentation et ajusté par réglage), dans une fraction du temps alloué pour le verrouillage de la boucle à phase asservie 2.

L'invention vise donc à tirer partie du nombre beaucoup plus important d'impulsions appliqué au comparateur de phase 3 dans le mode de fonctionnement à boucle à asservissement en phase (PLL) à division fractionnaire, pour réaliser le verrouillage de la boucle plus rapidement, sans avoir à supporter les inconvénients liés à l'implémentation et à la mise en oeuvre d'une telle boucle à division fractionnaire.

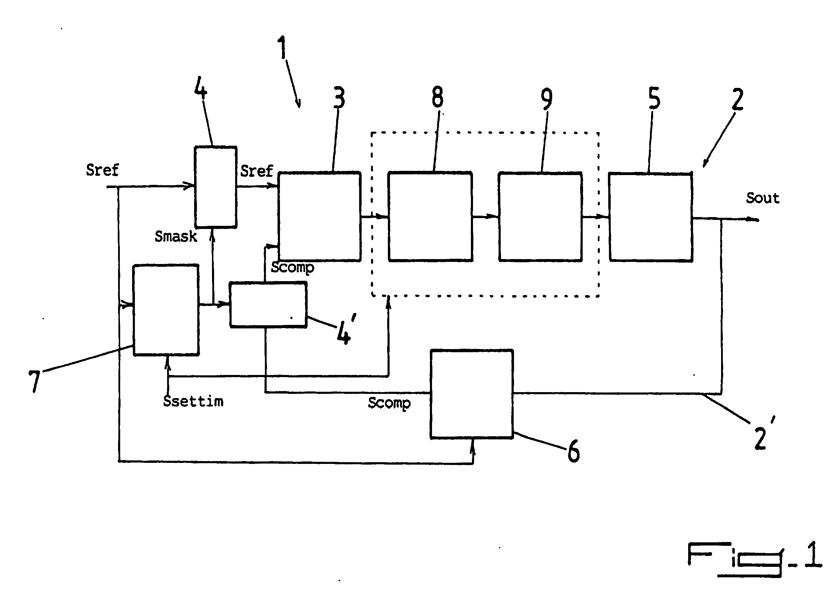

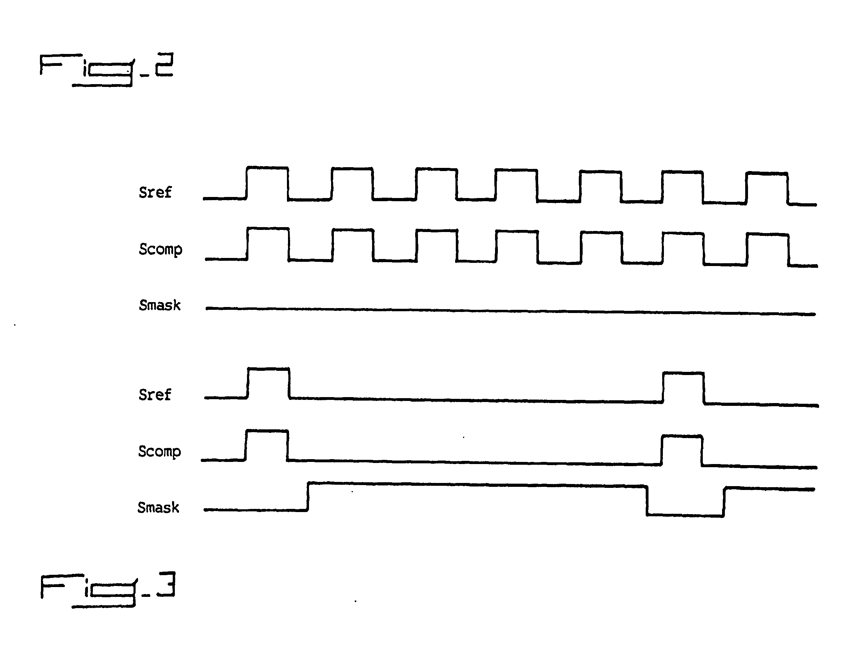

En effet, comme le montre notamment une comparaison des chronogrammes des figures 2 et 3, l'ensemble des impulsions des signaux Scomp et Sref présentes dans le mode de fonctionnement en PLL classique sont déjà présentes dans ces signaux dans le mode de fonctionnement en PLL à division fractionnaire, le passage du second mode au premier s'effectuant par simple application d'un masque ne conservant que les impulsions nécessaires dans ledit second mode de fonctionnement.

Selon un mode de réalisation préféré de l'invention, le masquage ou la suppression est réalisé(e) par génération d'un signal Smask opérant un filtrage des ou une discrimination parmi les impulsions du signal de référence Sref et du signal de comparaison Scomp issu de la chaîne de rétroaction 2' de ladite boucle à phase asservie 2.

Conformément à une première variante de réalisation, le signal Smask de masquage ou de suppression consiste en un signal à deux états et est appliqué, en tant que signal de commande de passage ou d'autorisation de passage, à des circuits 4, 4' formant verrous de transfert et montés en série dans la ligne de transmission du signal de référence Sref et dans la chaîne de rétroaction 2' immédiatement en amont des entrées du comparateur de phase 3.

Conformément à une second mode de réalisation, le signal Smask de masquage ou de suppression consiste en un signal à deux états et est appliqué, éventuellement après inversion, à l'une des entrées de circuits ET 4, 4' montés en série, l'un, dans la ligne de transmission du signal de référence Sref et, l'autre, dans la chaîne de rétroaction 2' et dont les sorties sont connectées aux entrées du comparateur de phase 3, les autres entrées desdits circuits ET 4, 4' recevant respectivement le signal de référence Sref et le signal de comparaison Scomp issu de la chaîne de rétroaction 2'.

La présente invention a également pour objet, comme le montre la figure 1 des dessins annexés, un dispositif 1 synthétiseur de fréquence à boucle à phase asservie 2, comprenant un générateur 5 (par exemple du type VCO) dont la fréquence contrôlée du signal de sortie est fonction du signal délivré par un comparateur de phase 3 dont les entrées reçoivent un signal de référence Sref et un signal de comparaison Scomp issu d'une chaîne de rétroaction 2' reliant la sortie dudit générateur à fréquence contrôlée 5 à l'une des entrées dudit comparateur de phase 3 et intégrant un diviseur de fréquence fractionnaire 6.

Ce dispositif 1 est caractérisé en ce qu'il comprend également un générateur 7 de signaux de masquage ou de suppression Smask appliqués, en tant que signaux de commande ou d'autorisation, à des circuits discriminateurs ou filtrants 4, 4' montés en série, l'un, dans la ligne de transmission du signal de référence Sref et, l'autre, dans la chaîne de rétroaction 2' immédiatement en amont des entrées correspondantes du comparateur de phase 3, la commutation d'un mode de fonctionnement en boucle à phase asservie à division fréquentielle fractionnaire en un mode de fonctionnement en boucle à phase asservie à division fréquentielle entière étant réalisée par application desdits signaux de masquage ou de suppression Smask.

Selon un mode de réalisation préféré de l'invention, le générateur 7 de signaux de masquage ou de suppression Smask délivre un signal à deux états ou carré, après un délai prédéterminé, dans une fraction du temps alloué pour le verrouillage de la boucle à phase asservie 2, ledit signal de masquage ou de suppression Smask étant réglable en termes de rapport cyclique.

Le dispositif 1 fonctionnera par conséquent, durant une phase transitoire de verrouillage, avec une boucle asservie en phase à division fractionnaire et, pendant le régime permanent, avec une boucle asservie en phase traditionnelle calée sur la fréquence souhaitée au niveau du signal de sortie Sout.

Pour assurer la synchronisation du fonctionnement des différents circuits constitutifs du dispositif 1, durant les phases de stabilisation, de verrouillage, de commutation et de fonctionnement permanent, le signal de référence Sref est appliqué, en tant que signal de séquencement, au générateur 7 de signaux de masquage ou de suppression Smask et au diviseur de fréquence fractionnaire 6.

En outre, un signal Ssettim d'indication de l'intervalle de temps alloué au verrouillage de la boucle à phase asservie 2 est délivré audit générateur 7 de signaux de masquage ou de suppression Smask et à un module [pompe à charge 8 / filtre intégrateur 9] monté entre la sortie du comparateur de phase 3 et l'entrée du générateur 5 du signal de sortie Sout dudit dispositif 1.

Les circuits discriminateurs ou filtrants 4, 4' peuvent, par exemple, consister en des circuits formant verrous de transfert ou en des portes logiques, par exemple du ET ou OU.

L'invention concerne également un terminal mobile de radiotélécommunication, comportant un dispositif synthétiseur de fréquence 1 tel que décrit ci-dessus et mettant en oeuvre le procédé précité.

## Revendications (Revendications pour l'(les) Etat(s) contractant(s) suivant(s): AT, BE, CH, DK, CY, ES, FI, GR, IE, IT, LI, LU, MC, NL, PT, SE, TR)

1. Procédé de synthèse de fréquence au moyen d'une boucle à phase asservie, comportant un comparateur de phase, comprenant notamment une étape de commutation d'un mode de fonctionnement à division fréquentielle fractionnaire en un mode de fonctionnement à division fréquentielle entière après écoulement du temps de stabilisation en fonctionnement de ladite boucle, procédé **caractérisé en ce qu'**il consiste à opérer ladite commutation de modes de fonctionnement en masquant une partie des impulsions des signaux de référence (Sref) et de comparaison (Scomp) avant leur application aux entrées du comparateur de phase (3).

2. Procédé selon la revendication 1, **caractérisé en ce que** ledit masquage débute après un délai prédéterminé, dans une fraction du temps alloué pour le verrouillage de la boucle à phase asservie (2).

3. Procédé selon l'une quelconque des revendications 1 et 2, **caractérisé en ce que** le masquage est réalisé(e) par génération d'un signal (Smask) opérant une discrimination parmi les impulsions du signal de référence (Sref) et du signal de comparaison (Scomp) issu de la chaîne de rétroaction (2') de ladite boucle à phase asservie (2).

4. Procédé selon la revendication 3, **caractérisé en ce que** le signal (Smask) de masquage consiste en un signal à deux états et est appliqué, éventuellement après inversion, à l'une des entrées de circuits ET (4, 4') montés en série, l'un, dans la ligne de transmission du signal de référence (Sref) et, l'autre, dans la chaîne de rétroaction (2') et dont les sorties sont connectées aux entrées du comparateur de phase (3), les autres entrées desdits circuits ET (4, 4') recevant respectivement le signal de référence (Sref) et le signal de comparaison (Scomp) issu de la chaîne de rétroaction (2').

5. Dispositif synthétiseur de fréquence à boucle à phase asservie, comprenant un générateur dont la fréquence contrôlée du signal de sortie est fonction du signal délivré par un comparateur de phase dont les entrées reçoivent un signal de référence et un signal de comparaison issu d'une chaîne de rétroaction reliant la sortie dudit générateur à fréquence contrôlée à l'une des entrées dudit comparateur de phase et intégrant un diviseur de fréquence fractionnaire, **caractérisé en ce qu'**il comprend également un générateur (7) de signaux de masquage (Smask) appliqués, en tant que signaux de commande à des circuits discriminateurs (4, 4') montés en série, l'un, dans la ligne de transmission du signal de référence (Sref) et, l'autre, dans la chaîne de rétroaction (2') immédiatement en amont des entrées correspondantes du comparateur de phase (3), la commutation d'un mode de fonctionnement en boucle à phase asservie à division fréquentielle fractionnaire en un mode de fonctionnement en boucle à phase asservie à division fréquentielle entière étant réalisée par application desdits signaux de masquage (Smask).

6. Dispositif selon la revendication 5, **caractérisé en ce que** le générateur (7) de signaux de masquage (Smask) délivre un signal à deux états ou carré, après un délai prédéterminé, dans une fraction du temps alloué pour le verrouillage de la boucle à phase asservie (2).

7. Dispositif selon l'une quelconque des revendications 5 et 6, **caractérisé en ce que** le signal de référence (Sref) est appliqué, en tant que signal de séquencement, au générateur (7) de signaux de masquage (Smask) et au diviseur de fréquence fractionnaire (6) et **en ce qu'**un signal (Ssettim) d'indication de l'intervalle de temps alloué au verrouillage de la boucle à phase asservie (2) est délivré audit générateur (7) de signaux de masquage (Smask) et à un module [pompe à charge (8) / filtre intégrateur (9)] monté entre la sortie du comparateur de phase (3) et l'entrée du générateur (5) du signal de sortie (Sout) dudit dispositif (1).

8. Dispositif selon l'une quelconque des revendications 5 à 7, **caractérisé en ce que** les circuits discriminateurs (4, 4') consistent en des circuits formant verrous de transfert.

9. Dispositif selon l'une quelconque des revendications 5 à 7, **caractérisé en ce que** les circuits discriminateurs (4, 4') consistent en des portes logiques.

10. Dispositif selon l'une quelconque des revendications 6 à 9, **caractérisé en ce que** le signal de masquage (Smask) est réglable en termes de rapport cyclique.

11. Terminal mobile de radiotélécommunication, **caractérisé en ce qu'**il comporte un dispositif synthétiseur de fréquence (1) selon l'une quelconque des revendications 5 à 10.

## Revendications (Revendications pour l'(les) Etat(s) contractant(s) suivant(s): DE, FR, GB)

1. Procédé de synthèse de fréquence au moyen d'une boude à phase asservie, comportant un comparateur de phase, comprenant notamment une étape de commutation d'un mode de fonctionnement à division fréquentielle fractionnaire en un mode de fonctionnement à division fréquentielle entière après écoulement du temps de stabilisation en fonctionnement de ladite boucle, procédé **caractérisé en ce qu'**il consiste à opérer ladite commutation de modes de fonctionnement en masquant une partie des impulsions des signaux de référence (Sref) et de comparaison (Scomp) avant leur application aux entrées du comparateur de phase (3).
et ce ce que ledit masquage débute après un délai prédéterminé, dans une fraction du temps alloué pour le verrouillage de la boucle à phase asservie (2).

2. Procédé selon revendication 1, **caractérisé en ce que** le masquage est réalisé(e) par génération d'un signal (Smask) opérant une discrimination parmi les impulsions du signal de référence (Sref) et du signal de comparaison (Scomp) issu de la chaîne de rétroaction (2') de ladite boucle à phase asservie (2).

3. Procédé selon la revendication 2, **caractérisé en ce que** le signal (Smask) de masquage consiste en un signal à deux états et est appliqué, éventuellement après inversion, à l'une des entrées de circuits ET (4, 4') montés en série, l'un, dans la ligne de transmission du signal de référence (Sref) et, l'outre, dans la chaîne de rétroaction (2') et dont les sorties sont connectées aux entrées du comparateur de phase (3), les autres entrées desdits circuits ET (4, 4') recevant respectivement le signal de référence (Sref) et le signal de comparaison (Scomp) issu de la chaîne de rétroaction (2').

4. Dispositif synthétiseur de fréquence à boude à phase asservie, comprenant un générateur dont la fréquence contrôlée du signal de sortie est fonction du signal délivré par un comparateur de phase dont les entrées reçoivent un signal de référence et un signal de comparaison issu d'une chaîne de rétroaction reliant la sortie dudit générateur à fréquence contrôlée à l'une des entrées dudit comparateur de phase et intégront un diviseur de fréquence fractionnaire, **caractérisé en ce qu'**il comprend également un générateur (7) de signaux de masquage (Smask) appliqués, en tant que signaux de commande à des circuits discriminateurs (4, 4') montés en série, l'un, dans la ligne de transmission du signal de référence (Sref) et, l'autre, dans la chaîne de rétroaction (2') immédiatement en amont des entrées correspondantes du comparateur de phase (3), la commutation d'un mode de fonctionnement en boucle à phase asservie à division fréquentielle fractionnaire en un mode de fonctionnement en boude à phase asservie à division fréquentielle entière étant réalisée par application desdits signaux de masquage (Smask), et
ce que le générateur (7) de signaux de masquage (Smask) délivre un signal à deux états ou carré, après un délai prédéterminé, dans une fraction du temps alloué pour le verrouillage de la boucle à phase asservie (2).

5. Dispositif selon la revendication **caractérisé en ce que** le signal de référence (Sret) est appliqué, en tant que signal de séquencement, ou générateur (7) de signaux de masquage (Smask) et au diviseur de fréquence fractionnaire (6) et **en ce qu'**un signal-(Ssettim) d'indication de l'intervalle de temps alloué au verrouillage de la boucle à phase asservie (2) est délivré audit générateur (7) de signaux de masquage (Smask) et à un module [pompe à charge (8) / filtre intégrateur (9)] monté entre la sortie du comparateur de phase (3) et l'entrée du générateur (5) du signal de sortie (Sout) dudit dispositif (1).

6. Dispositif selon l'une quelconque des revendications 4 a 5, **caractérisé en ce que** les circuits discriminateurs (4, 4') consistent en des circuits formant verrous de transfert.

7. Dispositif selon l'une quelconque des revendications 4 à 5, **caractérisé en ce que** les circuits discriminateurs (4, 4') consisistent en des portes logiques.

8. Dispositif selon l'une quelconque des revendications 5 à 7, **caractérisé en ce que** le signal de masquage (Smask) est réglable en termes de rapport cyclique.

9. Terminal mobile de radiotélécommunication, **caractérisé en ce qu'**il comporte un dispositif synthétiseur de fréquence (1) selon l'une quelconque des revendications 4 à 8.

## Claims (Claims for the following Contracting State(s): AT, BE, CH, CY, DK, ES, FI, GR, IE, IT, LI, LU, MC, NL, PT, SE, TR)

1. Frequency synthesis method using a phase locked loop, containing a phase comparator, comprising in particular a switching step from a fractional frequency division mode to an integer frequency division mode after lapse of the functioning stabilization time of said loop, method **characterized in that** it consists of performing said switching of functioning modes by masking part of the pulses of the reference signals (Sref) and comparison signals (Scomp) before they are applied to the inputs of the phase comparator (3).

2. Method as in claim 1, **characterized in that** said masking is initiated after a set time interval in a fraction of the time allotted for locking the phase locked loop (2).

3. Method as in either of claims 1 and 2, **characterized in that** masking is achieved by generating a signal (Smask) operating a discrimination among the pulses of the reference signal (Sref) and of the comparison signal (Scomp) derived from the feedback chain (2') of said phase locked loop (2).

4. Method as in claim 3, **characterized in that** the masking signal (Smask) consists of a two-state signal and is applied, optionally after inversion, to one of the inputs of AND circuits (4, 4') mounted in series, one in the transmission line of the reference signal (Sref) and the other in the feedback chain (2') and whose outputs are connected to the inputs of the phase comparator (3), the other inputs of said AND circuits (4,4') respectively receiving the reference signal (Sref) and the comparison signal (Scomp) derived from the feedback chain (2').

5. Frequency synthesizing device with phase locked loop comprising a generator whose controlled frequency of the output signal is dependent upon the signal delivered by a phase comparator whose inputs receive a reference signal and a comparison signal derived from a feedback chain connecting the output of said controlled frequency generator to one of the inputs of said phase comparator and integrating a fractional frequency divider, **characterized in that** it also comprises a generator (7) of masking signals (Smask) applied, as command signals, to discriminator circuits (4,4') mounted in series, one in the transmission line of the reference signal (Sref) and the other in the feedback chain (2') immediately upstream of the corresponding inputs of the phase comparator (3), the switching from a functioning mode in phase locked loop with fractional frequency division to a functioning mode in phase locked loop with integer frequency division being conducted by applying said masking signals (Smask).

6. Device as in claim 5, **characterized in that** the generator (7) of masking signals (Smask) delivers a two-state or square signal, after a set time interval, in a fraction of the time allotted for locking the phase locked loop (2).

7. Device as in either of claims 5 and 6, **characterized in that** the reference signal (Sref) is applied, as a sequencing signal, to the generator (7) of masking signals (Smask) and to the fractional frequency divider (6), and **in that** a signal (Ssetim) indicating the time allotted to locking of the phase locked loop (2) is delivered to said generator (7) of masking signals (Smask) and to a module [charge pump (8) / integrator filter (9)] mounted between the output of the phase comparator (3) and the input of the generator (5) of the output signal (Sout) of said device (1).

8. Device as in any of claims 5 to 7, **characterized in that** the discriminator circuits (4,4') consist of circuits forming transfer latches.

9. Device as in any of claims 5 to 7, **characterized in that** the discriminator circuits (4,4') consist of logic gates.

10. Device as in any of claims 6 to 9, **characterized in that** the masking signal (Smask) is adjustable in terms of cyclic ratio.

11. Mobile radio telecommunication terminal, **characterized in that** it comprises a frequency synthesizing device (1) as in any of claims 5 to 10.

## Claims (Claims for the following Contracting State(s): DE, FR, GB)

1. Frequency synthesis method using a phase locked loop, containing a phase comparator, comprising in particular a switching step from a fractional frequency division mode to an integer frequency division mode after lapse of the functioning stabilization time of said loop, method **characterized in that** it consists of performing said switching of functioning modes by masking part of the pulses of the reference signals (Sref) and comparison signals (Scomp) before they are applied to the inputs of the phase comparator (3), and **in that** said masking is initiated after a set time interval in a fraction of the time allotted for locking the phase locked loop (2).

2. Method as in claim 1, **characterized in that** masking is achieved by generating a signal (Smask) operating a discrimination among the pulses of the reference signal (Sref) and of the comparison signal (Scomp) derived from the feedback chain (2') of said phase locked loop (2).

3. Method as in claim 2, **characterized in that** the masking signal (Smask) consists of a two-state signal and is applied, optionally after inversion, to one of the inlets of the AND circuits (4, 5') mounted in series, one in the transmission line of the reference signal (Sref) and the other in the feedback chain (2') and whose outputs are connected to the inputs of the phase comparator (3), the other inputs of said AND circuits (4,4') respectively receiving the reference signal (Sref) and the comparison signal (Scomp) derived from the feedback chain (2').

4. Frequency synthesizing device with phase locked loop comprising a generator whose controlled frequency of the output signal is dependent upon the signal delivered by a phase comparator whose inputs receive a reference signal and a comparison signal derived from a feedback chain connecting the output of said controlled frequency generator to one of the inputs of said phase comparator and integrating a fractional frequency divider, **characterized in that** it also comprises a generator (7) of masking signals (Smask) applied, as command signals, to discriminator circuits (4,4') mounted in series, one in the transmission line of the reference signal (Sref) and the other in the feedback chain (2') immediately upstream of the corresponding inputs of the phase comparator (3), the switching from a functioning mode in phase locked loop with fractional frequency division to a functioning mode in phase locked loop with integer frequency division being conducted by applying said masking signals (Smask), and **in that** the generator (7) of masking signals (Smask) delivers a two-state or square signal, after a set time, in a fraction of the time allotted for locking the phase locked loop (2).

5. Device as in claim 4, **characterized in that** the reference signal (Sref) is applied, as a sequencing signal, to the generator (7) of masking signals (Smask) and to the fractional frequency divider (6), and **in that** a signal (Ssetim) indicating the time allotted to locking of the phase locked loop (2) is delivered to said generator (7) of masking signals (Smask) and to a module [charge pump (8) / integrator filter (9)] mounted between the output of the phase comparator (3) and the input of the generator (5) of the output signal (Sout) of said device (1).

6. Device as in either of claims 4 to 5, **characterized in that** the discriminator circuits (4, 4') consist of circuits forming transfer latches.

7. Device as in either of claims 4 to 5, **characterized in that** the discriminator circuits (4,4') consist of logic gates.

8. Device as in any of claims 5 to 7, **characterized in that** the masking signal (Smask) is adjustable in terms of cyclic ratio.

9. Mobile radio telecommunication terminal, **characterized in that** it comprises a frequency synthesizing device (1) as in any of claims 4 to 8.

## Patentansprüche (Patentansprüche für folgende(n) Vertragsstaat(en): AT, BE, CH, DK, CY, ES, FI, GR, IE, IT, LI, LU, MC, NL, PT, SE, TR)

1. Verfahren zur Frequenzsynthese mittels einer einen Phasenkomparator aufweisenden Schleife mit geregelter Phase, das insbesondere einen Schritt des Umschaltens von einem Betriebsmodus mit Frequenz-Bruchteilung in einen Betriebsmodus mit ganzzahliger Frequenzteilung nach Ablauf der Stabilisierungszeit im Betrieb der Schleife umfasst, **dadurch gekennzeichnet, dass** es darin besteht, die Umschaltung der Betriebsmodi vorgenommen wird, indem ein Teil der Impulse der Bezugs- (Sref) und Vergleichssignale (Scomp) maskiert wird, bevor sie auf die Eingänge des Phasenkomparators (3) gegeben werden.

2. Verfahren nach Anspruch 1, **dadurch gekennzeichnet, dass** die Maskierung nach einer vorher festgelegten Verzögerung in einem Bruchteil der Zeit beginnt, die für die Verriegelung der Schleife mit geregelter Phase zugewiesen ist.

3. Verfahren nach einem der Ansprüche 1 und 2, **dadurch gekennzeichnet, dass** die Maskierung durch Erzeugung eines Signals (Smask) ausgeführt wird, das eine Unterscheidung zwischen den Impulsen des Bezugssignals (Sref) und des Vergleichssignals (Scomp) vornimmt, das aus der Rückkopplungskette (2') der Schleife mit geregelter Phase (2) stammt.

4. Verfahren nach Anspruch 3, **dadurch gekennzeichnet, dass** das Maskierungssignal (Smask) aus einem Signal mit zwei Zuständen besteht und, eventuell nach Inversion, auf einen der Eingänge von in Reihe angebrachten UND-Schaltungen (4, 4') gegeben wird, die eine in der Übertragungsleitung für das Bezugssignal (Sref) und die andere in der Rückkopplungskette (2') und deren Ausgänge mit den Eingängen des Phasenkomparators (3) verbunden sind, wobei die anderen Eingänge der UND-Schaltungen (4, 4') jeweils das Bezugssignal (Sref) und das Vergleichssignal (Scomp) empfangen, das von der Rückkopplungskette (2') stammt.

5. Frequenzsynthesevorrichtung mit einer Schleife mit geregelter Phase, die einen Generator umfasst, dessen kontrollierte Frequenz des Ausgangssignals von dem Signal abhängt, das von einem Phasenkomparator geliefert wird, dessen Eingänge ein Bezugssignal und ein Vergleichssignal empfangen, das von einer Rückkopplungskette stammt, die den Ausgang des Generators mit kontrollierter Frequenz mit einem der Eingänge des Phasenkomparators verbindet und einen Frequenz-Bruchteiler integriert, **dadurch gekennzeichnet, dass** sie auch einen Generator (7) für Maskierungssignale (Smask) umfasst, die als Steuersignale an in Reihe angebrachte Diskriminatorschaltungen (4, 4') gegeben werden, eine in der Übertragmgsleitung des Bezugssignals (Sref) und die andere in der Rückkopplungskette (2') direkt stromaufwärts der entsprechenden Eingänge des Phasenkomparators (3), wobei die Umschaltung von einem Betriebsmodus mit Frequenz-Bruchteilung in der Schleife mit geregelter Phase in einen Betriebsmodus mit ganzzahliger Frequenzteilung in der Schleife mit geregelter Phase durch Anwendung der Maskierungssignale (Smask) ausgeführt wird.

6. Vorrichtung nach Anspruch 5, **dadurch gekennzeichnet, dass** der Generator (7) für Maskierungssignale (Smask) nach einer vorher festgelegten Verzögerung in einem Bruchteil der Zeit, die für die Verriegelung der Schleife mit geregelter Phase (2) zugewiesen ist, ein Signal mit zwei Zuständen oder einen Rechteckimpuls liefert.

7. Vorrichtung nach einem der Ansprüche 5 und 6, **dadurch gekennzeichnet, dass** das Bezugssignal (Sref) als Sequenzierungssignal an den Generator (7) für Maskierungssignale (Smask) und an den Frequenz-Bruchteiler (6) gegeben und dass ein Signal (Ssettim) zur Angabe des Zeitintervalls, das der Verriegelung der Schleife mit geregelter Phase (2) zugewiesen ist, an den Generator (7) für Maskierungssiganle (Smask) und an ein Modul [Pumpe unter Last (8) / Integrierfilter (9)] gegeben wird, das zwischen dem Ausgang des Phasenkomparators (3) und dem Eingang des Generators (5) für das Ausgangssignal (Sout) der Vorrichtung (1) angebracht ist.

8. Vorrichtung nach einem der Ansprüche 5 bis 7, **dadurch gekennzeichnet, dass** die Diskriminatorschaltungen (4,4') in Schaltungen bestehen, die eine Übertragungssperre bilden.

9. Vorrichtung nach einem der Ansprüche 5 bis 7, **dadurch gekennzeichnet, dass** die Diskriminatorschaltungen (4, 4') in logischen Gattern bestehen.

10. Vorrichtung nach einem der Ansprüche 6 bis 9, **dadurch gekennzeichnet, dass** das Maskierungssignal (Smask) bezüglich des Tastverhältnisses regelbar ist.

11. Mobiles Endgerät für die Funktelekommunikation, **dadurch gekennzeichnet, dass** es eine Frequenzsynthesevorrichtung (1) nach einem der Ansprüche 5 bis 10 aufweist.

## Patentansprüche (Patentansprüche für folgende(n) Vertragsstaat(en): DE, FR, GB)

1. Verfahren zur Frequenzsynthese mittels einer einen Phasenkomparator aufweisenden Schleife mit geregelter Phase, das insbesondere einen Schritt des Umschaltens von einem Betriebsmodus mit Frequenz-Bruchteilung in einen Betriebsmodus mit ganzzahliger Frequenzteilung nach Ablauf der Stabilisierungszeit im Betrieb der Schleife umfasst, **dadurch gekennzeichnet, dass** es darin besteht, die Umschaltung der Betriebsmodi vorgenommen wird, indem ein Teil der Impulse der Bezugs- (Sref) und Vergleichssignale (Scomp) maskiert wird, bevor sie auf die Eingänge des Phasenkomparators (3) gegeben werden, und
dass die Maskierung nach einer vorher festgelegten Verzögerung in einem Bruchteil der Zeit beginnt, die für die Verriegelung der Schleife mit geregelter Phase zugewiesen ist.

2. Verfahren nach Anspruch 1, **dadurch gekennzeichnet, dass** die Maskierung durch Erzeugung eines Signals (Smask) ausgeführt wird, das eine Unterscheidung zwischen den Impulsen des Bezugssignals (Sref) und des Vergleichssignals (Scomp) vornimmt, das aus der Rückkopplungskette (2') der Schleife mit geregelter Phase (2) stammt.

3. Verfahren nach Anspruch 2, **dadurch gekennzeichnet, dass** das Markierungssignal (Smask) aus einem Signal mit zwei Zuständen besteht und, eventuell nach Inversion, auf einen der Eingänge von in Reihe angebrachten UND-Schaltungen (4, 4') gegeben wird, die eine in der Übertragungsleitung für das Bezugssignal (Sref) und die andere in der Rückkopplungskette (2') und deren Ausgänge mit den Eingängen des Phasenkomparators (3) verbunden sind, wobei die anderen Eingänge der UND-Schaltungen (4, 4') jeweils das Bezugssignal (Sref) und das Vergleichssignal (Scomp) empfangen, das von der Rückkopplungskette (2') stammt.

4. Frequenzsynthesevorrichtung mit einer Schleife mit geregelter Phase, die einen Generator umfasst, dessen kontrollierte Frequenz des Ausgangssignals von dem Signal abhängt, das von einem Phasenkomparator geliefert wird, dessen Eingänge ein Bezugssignal und ein Vergleichssignal empfangen, das von einer Rückkopplungskette stammt, die den Ausgang des Generators mit kontrollierter Frequenz mit einem der Eingänge des Phasenkomparators verbindet und einen Frequenz-Bruchteiler integriert, **dadurch gekennzeichnet, dass** sie auch einen Generator (7) für Maskierungssignale (Smask) umfasst, die als Steuersignale an in Reihe angebrachte Diskriminatorschaltungen (4,4') gegeben werden, eine in der Übertragungsleitung des Bezugssignals (Sref) und die andere in der Rückkopplungskette (2') direkt stromaufwärts der entsprechenden Eingähge des Phasenkomparators (3), wobei die Umschaltung von einem Betriebsmodus mit Frequenz-Bruchteilung in der Schleife mit geregelter Phase in einen Betriebsmodus mit ganzzahliger Frequenzteilung in der Schleife mit geregelter Phase durch Anwendung der Maskierungssignale (Smask) ausgeführt wird, und dass der Generator (7) für Maskierungssignale (Smask) nach einer vorher festgelegten Verzögerung in einem Bruchteil der Zeit, die für die Verriegelung der Schleife mit geregelter Phase (2) zugewiesen ist, ein Signal mit zwei Zuständen oder einen Rechteckimpuls liefert.

5. Vorrichtung nach Anspruch 4, **dadurch gekennzeichnet, dass** das Bezugssignal (Sref) als Sequenzierungssignal an den Generator (7) für Maskierungssignale (Smask) und an den Frequenz-Bruchteiler (6) gegeben und dass ein Signal (Ssettim) zur Angabe des Zeitintervalls, das der Verriegelung der Schleife mit geregelter Phase (2) zugewiesen ist, an den Generator (7) für Maskierungssiganle (Smask) und an ein Modul [Pumpe unter Last (8) / Integrierfilter (9)] gegeben wird, das zwischen dem Ausgang des Phasenkomparators (3) und dem Eingang des Generators (5) für das Ausgangssignal (Sout) der Vorrichtung (1) angebracht ist.

6. Vorrichtung nach einem der Ansprüche 4 bis 5, **dadurch gekennzeichnet, dass** die Diskriminatorschaltungen (4, 4') in Schaltungen bestehen, die eine Übertragungssperre bilden.

7. Vorrichtung nach einem der Ansprüche 4 bis 5, **dadurch gekennzeichnet, dass** die Diskriminatorschaltungen (4, 4') in logischen Gattern bestehen.

8. Vorrichtung nach einem der Ansprüche 5 bis 7, **dadurch gekennzeichnet, dass** das Maskierungssignal (Smask) bezüglich des Tastverhältnisses regelbar ist.

9. Mobiles Endgerät für die Funktelekommunikation, **dadurch gekennzeichnet, dass** es eine Frequenzsynthesevorrichtung (1) nach einem der Ansprüche 4 bis 8 aufweist.
